## Europäisches Patentamt

## European Patent Office

## Office européen des brevets

(11) Veröffentlichungsnummer: **0 095 590**
A1

(12) **EUROPÄISCHE PATENTANMELDUNG**

(21) Anmeldenummer: 83104385.6

(22) Anmeldetag: 04.05.83

(51) Int. Cl.³: **H 02 H 3/44,** H 02 H 5/04, G 01 R 19/12

(30) Priorität: 29.05.82 DE 3220434

(43) Veröffentlichungstag der Anmeldung: 07.12.83 Patentblatt 83/49

(84) Benannte Vertragsstaaten: DE FR GB IT

(71) Anmelder: **ROBERT BOSCH GMBH, Postfach 50, D-7000 Stuttgart 1 (DE)**

(72) Erfinder: **Bressert, Edgar, Schulbergstrasse 3, D-7141 Schwieberdingen (DE)**
Erfinder: **Gulich, Gerhard, Eisenauerweg 51a, D-7000 Stuttgart 80 (DE)**
Erfinder: **Martini, Helmut, Dipl.-Ing., Kalkofenweg 23/3, D-7252 Weil der Stadt (DE)**
Erfinder: **Meny, Rudi, Spitalhofstrasse 27, D-7000 Stuttgart 40 (DE)**
Erfinder: **Sauer, Roland, Dipl.-Ing., Pirolweg 3, D-7000 Stuttgart 31 (DE)**
Erfinder: **Wöhr, Rolf, Karlstrasse 17, D-7250 Leonberg (DE)**

(54) **Verfahren zur Überwachung einer Messgrösse.**

(57) Es wird ein dynamisches Verfahren zur Überwachung einer Meßgröße vorgeschlagen, bei dem die Meßanordnung (16, 17, 24, 27) die zeitliche Änderung der Meßgröße erfaßt und beim Überschreiten einer vorgegebenen Änderung ein Steuersignal liefert. In einer ersten Ausführungsform wird die Meßgröße als elektrische Spannung dargestellt, welche über unterschiedliche Schaltkreise (12, 13), von denen eine ein Verzögerungsglied (R, C) enthält, einem Differenzverstärker (16, 24) zugeführt wird. Bei einer anderen Ausführungsform erfolgt die Überwachung derart, daß die von einem Geber (10) erfaßte Meßgröße nach einer Analog-Digital-Umwandlung auf einen Mikrocomputer mit Speicher gegeben wird, welcher die Meßgrößendifferenz ($T_2 - T_1$) zu den verschiedenen Zeitpunkten (t1, t2) errechnet und bei Überschreiten einer vorgegebenen Meßgrößendifferenz (Tmin) ein Steuersignal liefert.

0095590

R.
19.5.1982 Rs/Le

ROBERT BOSCH GMBH, 7000 STUTTGART 1

## Verfahren zur Überwachung einer Meßgröße

Stand der Technik

Die Erfindung geht aus von einem Verfahren zur Überwachung einer Meßgröße nach der Gattung des Hauptanspruches. Bekannte Überwachungsverfahren erfassen einen oberen Grenzwert und setzen beim Überschreiten des Grenzwertes z.B. eine angeschlossene Anlage still. Dieses Verfahren hat jedoch einerseits den Nachteil, daß verhältnismäßig viel Zeit verstreicht bis zum Erreichen des Grenzwertes und daß andererseits häufig hohe Belastungen der angeschlossenen Anlage in Kauf genommen werden, welche nahe der Schadensgrenze liegen. So fließen beispielsweise sehr hohe elektrische Ströme in elektrochemischen Metallbearbeitungsanlagen bereits im normalen Betrieb; zur Erfassung des Kurzschlußstromes, welcher erhebliche Schäden verursachen kann, steht nur eine sehr kurze Zeitspanne zur Verfügung. Bekannte thermische Überwachungsanlagen zur Erfassung des Temperaturverlaufes in einer thermischen Entgratanlage bereiten

...

die Schwierigkeit, daß die Anlage sich im Laufe des
Betriebs erwärmt, so daß fortlaufend Korrekturen des
zulässigen Grenzwertes erforderlich sind um thermische
Vorgänge im Inneren der Anlage, insbesondere den erfolgten
Zündvorgang, zu überwachen.

Vorteile der Erfindung

Das erfindungsgemäße Verfahren mit den kennzeichnenden
Merkmalen des Hauptanspruches hat demgegenüber den Vorteil, daß durch die Erfassung des zeitlichen Verlaufes
der Meßgröße das Abwarten bis zum Erreichen eines Grenzwertes entfällt, so daß die Gesamtmessung sehr viel
rascher und frühzeitiger abgeschlossen werden kann. Die
Messung ist weiterhin unabhängig von dem Absolutwert
der Meßgröße, so daß die Kompensation einer sich verändernden Meßgröße entfällt. Beim Überwachen großer
Kurzschlußströme erreicht man ein schnelleres und
wirkungsvolleres Abschalten einer elektrischen Anlage,
weil der Kurzschluß bereits im Entstehen erfaßt
wird, unabhängig von der Größe des Arbeitsstromes.

Durch die in den Unteransprüchen aufgeführten Maßnahmen
sind vorteilhafte Ausgestaltungen des erfindungsgemäßen
Meßverfahrens sowie zweckmäßige Schaltungsanordnungen
zur Durchführung des Verfahrens angegeben. Als vorteilhaftes Meßverfahren eignet sich einerseits der Einsatz
eines Mikrocomputers bei der Bestimmung des Meßwertunterschiedes zu den verschiedenen vorgegebenen Zeitpunkten, andererseits hat sich ein analoges Meßverfahren
wegen seiner schnellen Arbeitsweise besonders bewährt
welches mit einem Differenzverstärker arbeitet. Die zugehörige Schaltungsanordnung kann so aufgebaut sein, daß auf
die beiden Eingänge des Differenzverstärkers das gleiche
Meßsignal gegeben, in einem Eingangszweig jedoch durch

. . .

ein Verzögerungsglied mit zunehmender Steilheit der
Kennlinie stärker verzögert wird. Die Schaltungsanordnung kann mit Vorteil jedoch auch so aufgebaut
werden, daß das Meßgrößensignal in einem Schaltungszweig verzögert und dieses nach Invertierung eines
Zweigsignales mit dem anderen Signal zusammen auf
den gleichen Eingang eines Differenzverstärkers und
eines Komparators gegeben wird. Die Differenzbildung
erfolgt dann vor dem Verstärkereingang.

Weitere Einzelheiten und schaltungstechnische Maßnahmen
zum erfindungsgemäßen Verfahren ergeben sich aus den
Unteransprüchen und der Beschreibung der Ausführungsbeispiele.

Zeichnung

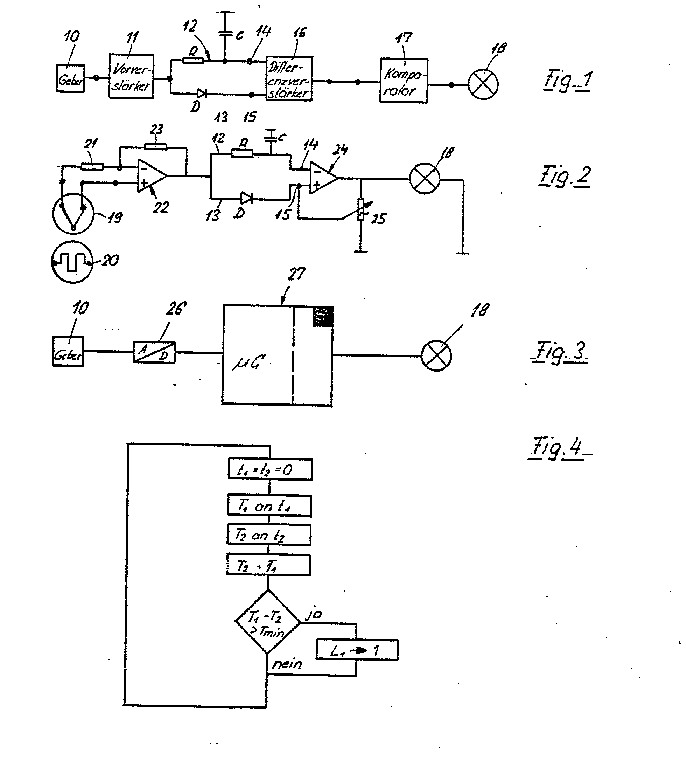

Zwei Ausführungsbeispiele der Erfindung sind in der Zeichnung schematisch dargestellt und in der nachfolgenden
Beschreibung näher erläutert. Es zeigen Figur 1 das
Prinzipschaltbild eines ersten Ausführungsbeispiels in
Analogtechnik, Figur 2 eine Prinzipschaltung für eine
Überwachungsanordnung gemäß Figur 1, Figur 3 ein zweites Ausführungsbeispiel zur Realisierung des Überwachungsverfahrens in Digitaltechnik und Figur 4 ein Flußdiagramm
zur Erläuterung des Verfahrens gemäß Figur 3.

Beschreibung der Ausführungsbeispiele

In Figur 1 ist mit 10 ein Geber bezeichnet, dessen Ausgang an einen Vorverstärker 11 angeschlossen ist. Der
Ausgang des Vorverstärkers 11 ist über Schaltkreise 12
und 13 mit zwei Eingängen 14 und 15 eines Differenzverstärkers 16 verbunden. Im Schaltkreis 12 ist ein Verzögerungsglied angeordnet mit einem Widerstand R und
einem Kondensator C. Im Schaltkreis 13 liegt eine Diode
D. An den Ausgang des Differenzverstärkers 16 ist ein
Komparator 17 angeschlossen, welcher einen als Glühlampe
18 dargestellten beliebigen Schaltkreis steuert.

...

- 4 -

Die Anordnung gemäß Figur 1 arbeitet so, daß der Geber 10 eine Meßgröße erfaßt und deren zeitlichen Verlauf nach einer Verstärkung im Vorverstärker 11 gleichzeitig auf die beiden Schaltkreise 12 und 13 aufschaltet, welche zu den beiden Eingängen 14 und 15 des Differenzverstärkers 16 führen. Im Schaltkreis 13 ist die Diode D angeordnet zur Erzeugung eines konstanten Spannungsabfalls von 0,7 Volt, im Schaltkreis 12 liegt als Verzögerungsglied ein RC-Glied, welches eingehende Meßgrößenänderungen, die als Spannungen am Schaltkreis 12 erscheinen, verzögert. Bei einem raschen Anstieg der vom Geber 10 erfaßten Meßgröße wird also der Spannungsanstieg am Eingang 14 des Differenzverstärkers 16 verzögert gegenüber dem Spannungsanstieg an dessen Eingang 15, so daß die entstehende Spannungsdifferenz einen vorgegebenen Wert überschreitet. Im Komparator 17 wird er Vergleich der entstehenden Spannungsdifferenz mit dem vorgegebenen Sollwert durchgeführt und beim Überschreiten der vorgegebenen Spannungsdifferenz die Glühlampe 18 eingeschaltet. Die Diode D im Schaltkreis 13 stabilisiert die Anordnung derart, daß der auftretende Spannungsabfall von 0,7 Volt zuerst überwunden werden muß und unbedeutende langsame Spannungsänderungen am Differenzverstärker 16 nicht wirksam werden können.

Figur 2 zeigt ein vereinfachtes Schaltungsbeispiel einer Anordnung gemäß Figur 1. Der Geber 10 kann dabei entweder ein Thermoelement 19 oder beispielsweise ein Shunt 20 sein. Die Ausgangsspannung des Thermoelementes 19 oder des Shunts 20 wird über einen Vorwiderstand 21 auf die beiden Eingänge eines Operationsverstärkers 22 gegeben, zwischen dessen Ausgang und invertierendem Eingang eine Gegenkopplung mit einem Widerstand 23 vorgesehen ist. Der Operationsverstärker 22 bildet den Vorverstärker 11

...

dessen Ausgang über die beiden Schaltkreise 12 und 13 mit der RC-Verzögerungsschaltung und der Diode D mit den beiden Eingängen 14 und 15 eines Operationsverstärkers 24 verbunden ist. Der Operationsverstärker 24 bildet gleichzeitig den Differenzverstärker 16 und den Komparator 17 gemäß Figur 1. Sein Ausgang ist über einen veränderlichen Widerstand 25 zur Erzeugung einer Schalterfunktion auf den nichtinvertierenden Eingang 15 mitgekoppelt, durch die Veränderung des Widerstandes 25 kann die Schalthysterese des Operationsverstärkers 24 verändert werden. Der zu schaltende Verbraucher am Ausgang des Operationsverstärkers 24 ist wiederum als Glühlampe dargestellt, deren zweiter Anschluß an Masse liegt, ebenso wie der zweite Anschluß des veränderlichen Widerstands 25.

Die Schaltungsanordnung gemäß Figur 2 wirkt in der anhand von Figur 1 beschriebenen Weise. Die Art des verwendeten Gebers 10 richtet sich nach der Art der Meßgröße. So wird bei einer vorteilhaften Verwendung des erfindungsgemäßen Überwachungsverfahrens zur Bestimmung der erfolgten Zündung und der sich hernach einstellenden Temperatur in einer thermischen Entgratanlage als Geber ein Thermoelement 19 verwendet. Bei einer anderen sehr vorteilhaften Anwendung des vorgeschlagenen Überwachungsverfahren zur Erfassung des Stromes, insbesondere des Kurschlußstromes in einer elektrochemischen Metallbearbeitungsanlage, wird ein sehr niederohmiger Shunt 20 als Geber 10 verwendet, welcher unmittelbar in den Arbeitsstromkreis eingeschaltet werden kann. Der vom Geber 10, 19, 20 gelieferte Spannungswert wird nach Verstärkung im Operationsverstärker 22 an die Schaltkreise 12 und 13 angelegt. Bei einer raschen Änderung der Meßgröße wird der Spannungsanstieg im Schaltkreis 12 zunächst nicht

...

weitergegeben auf den Eingang 14 des Operationsverstärkers 24, während im Schaltkreis 13 nach Abzug eines Spannungsabfalls von 0,7 Volt an der Diode D der Meßwertanstieg sofort an den nichtinvertierenden Eingang 15 des Operationsverstärkers 24 angelegt wird. Bei einer entsprechend schnellen und starken Veränderung der Meßgröße wird die vorgegebene Vergleichsgröße überschritten und am Ausgang des Operationsverstärkers 24 tritt ein Schaltsignal für den angeschlossenen Schaltkreis auf; die Glühlampe 18 oder ein anderer Verbraucher oder ein Steuerglied werden eingeschaltet.

Das zuvor beschriebene analoge Überwachungsverfahren sichert ein frühzeitiges Erfassen von Veränderungen einer Meßgröße, insbesondere von Stromänderungen einer elektrochemischen Metallbearbeitungsanlage oder von Temperaturveränderungen bei einer thermischen Entgratanlage. Im ersten Fall wird die Stromüberwachung in besonders vorteilhafter Weise eingesetzt zur Überwachung und frühzeitigen Erkennung eines Kurzschlusses in der elektrochemischen Metallbearbeitungsanlage, im zweiten Fall lassen sich besonders rasch und sicher Temperaturveränderungen messen, welche zur Überwachung des Zündvorganges im Brennraum einer thermischen Entgratanlage dienen. Bei dem vorgeschriebenen Verfahren muß nicht mehr das Erreichen eines Grenzwertes abgewartet werden, wie dies bislang bei entsprechenden Überwachungsverfahren notwendig war. Die dynamische Überwachung der Meßgröße erfolgt im wesentlichen derart, daß ein Eingang eines Differenzverstärkers über das RC-Glied verzögert beaufschlagt wird, so daß bei einer schnellen Änderung des vom Geber 10 gelieferten Steuersignals sich eine größere Differenz an den Eingängen 14 und 15 des Differenzverstärkers 16 bildet und dieser bei Überschreiten eines vorgegebenen Wertes durchschaltet. Über das RC-Glied und die Ansprechschwelle des Differenzverstärkers 16 in Verbindung mit dem Komparator 17 wird also der Grenzwert der Anstiegsgeschwindigkeit des vom Geber 10 gelieferten Steuersignals festgelegt, bei dem ein Ausgangssignal abgegeben
wird. Dieses Meßverfahren ist unabhängig vom Absolutwert der Meßgröße und kann daher mit besonderem Vorteil
beispielsweise bei einer thermischen Entgratanlage eingesetzt werden, weil die mit zunehmender Einsatzdauer
ansteigende Temperatur der Anlage nicht in das Meßverfahren eingeht. Es ist also keine Temperaturkompensation
mehr erforderlich, welche bei einer Anlage mit Erfassung
nur eines Grenzwertes zwingend erforderlich wäre. Außerdem kann die Taktzeit der Anlage wesentlich erhöht werden,
wenn die erfolgte Zündung in der Brennkammer schneller
nach außen gemeldet wird. Bei einer elektrochemischen
Metallbearbeitungsanlage ergibt sich in besonders vorteilhafter Weise ein schnelleres und wirkungsvolleres
Abschalten bei Kurzschluß, da dieser schon im Entstehen
erfaßt wird, unabhängig von der Größe des Arbeitsstromes.
Die Kurzschlußerfassung spielt bei derartigen Anlagen
eine besonders wichtige Rolle wegen der ohnehin sehr
hohen Arbeitsströme in der Größenordnung von bis zu 40.000
Ampere, wo Kurzschlüsse in der Anlage erhebliche Schäden
verursachen können.

Figur 3 zeigt eine andere Schaltungsanordnung zur Realisierung des erfindungsgemäßen Verfahrens zur dynamischen Überwachung einer Meßgröße. Hierbei wird die Meßgröße wiederum von einem Geber 10 erfaßt und zunächst
in einem Analog-Digital-Wandler in eine digitale Größe
umgeformt, welche in einem Mikrocomputer 27 mit Speicher
einer Rechenoperation zur Ermittlung der Meßgrößenänderung unterworfen wird. Beim Erreichen der vorgegebenen
Meßgrößenänderung erfolgt die Abgabe eines Steuersignals, beispielsweise wiederum für eine Glühlampe 18.

...

Als Geber 10 kann wiederum ein Thermoelement 19
oder ein Shunt 20 dienen, der Analog-Digital-
Wandler ist in bekannter Weise aufgebaut und braucht
hier nicht näher erörtert zu werden. Auch die Auswahl
des verwendeten Mikrocomputers 27 steht dem Fachmann
frei, beispielsweise könnte ein Mikrocomputer vom Typ
8085 der Firma Intel eingesetzt werden.

Figur 4 zeigt das Flußdiagramm zur Erläuterung der
Wirkungsweise einer Anordnung gemäß Figur 3. Zum Startzeitpunkt t1 = t2 = 0 beginnt der Meßvorgang. In einer
ersten Messung zum Zeitpunkt t1 erfaßt der Geber 10 den
Wert der Meßgröße, im dargestellten Fall die Temperatur
T1, welche in dem Mikrocomputer gespeichert wird. Nach
einer vorgegebenen Zeitdifferenz wird zum Zeitpunkt t2
vom Geber 10 eine weitere Temperaturmessung durchgeführt
und der gemessene Wert T2 ebenfalls gespeichert. Die
Steuerung bildet nun die Temperaturdifferenz T2-T1,
welche anschließend mit einem vorgegebenen Wert Tmin
verglichen wird. Bei der zuvor erwähnten thermischen
Entgratanlage ist der Wert Tmin abhängig von dem verwendeten Gemisch des gezündeten Gases und von der
Konstruktion der Brennkammer. Beim Überschreiten der
Mindesttemperaturdifferenz Tmin wird der Ausgang L1
auf 1 gesetzt, dies entspricht dem Aufleuchten der
Glühlampe 18. Ist die vorgegebene Mindesttemperaturdifferenz Tmin nicht erreicht, wird die gleiche Schleife
erneut durchlaufen.

Beim geschilderten Ausführungsbeispiel zur Erfassung
der Zündung in einer thermischen Entgratanlage, welche
eine Erwärmung der Anlage verursacht, ist die Erfassung
des Temperaturanstieges im Gegensatz zur Erfassung eines
Schwellwertes unabhängig von der tatsächlichen Temperatur
in der Brennkammer oder der Temperatur der Anlage. So wird

...

mit einfachen Mitteln eine rasche und sichere Erfassung des Zündzeitpunktes ermöglicht.

R.

19.5.1982 Rs/Hm

ROBERT BOSCH GMBH, 7000 STUTTGART 1

Ansprüche

1. Verfahren zur Überwachung einer Meßgröße, welche einer Meßanordnung zugeführt wird, die beim Überschreiten eines Grenzwertes ein Steuersignal liefert, insbesondere zur Überwachung des Bearbeitungsstromes einer elektrochemischen Metallbearbeitungsanlage oder des Temperaturverlaufes in einer thermischen Entgratanlage, dadurch gekennzeichnet, daß die Meßanordnung (12, 13, 16, 24, 27) die zeitliche Änderung der Meßgröße erfaßt und beim Überschreiten einer vorgegebenen Änderung unabhängig vom Absolutwert der Meßgröße das Steuersignal liefert.

2. Verfahren nach Anspruch 1, dadurch gekennzeichnet, daß die von einem Geber (10) zu aufeinanderfolgenden, festgesetzten Zeitpunkten (t1, t2) erfaßten Meßgrößen (T1, T2) auf einen Mikrocomputer (27) mit Speicher gegeben werden, welcher die Meßgrößendifferenz aus den zu verschiedenen Zeitpunkten gemessenen Werten errechnet und bei Überschreiten einer vorgegebenen Meßgrößendifferenz (Tmin) das Steuersignal liefert.

3. Verfahren nach Anspruch 1, dadurch gekennzeichnet, daß die Meßgröße als elektrische Spannung dargestellt wird, welche über unterschiedliche Schaltkreise (12, 13), von denen einer ein Verzögerungsglied (R, C) enthält, einem Differenzverstärker (16, 17, 24) zugeführt wird.

. . . .

4. Schaltungsanordnung zur Durchführung des Verfahrens
nach Anspruch 3, dadurch gekennzeichnet, daß die Spannung
eines Meßwertgebers (10, 19, 20) über ein RC-Glied in
einer Zuleitung (12) verzögert an einem Eingang (14) des
Differenzverstärkers (16) angelegt wird.

5. Schaltungsanordnung nach Anspruch 4, dadurch gekennzeichnet, daß die Meßspannung über das Verzögerungsglied (R, C) an den invertierenden Eingang (14) und über
einen Schwellenglied (D) an den nichtinvertierenden
Eingang (15) eines als Differenzverstärker arbeitenden
Operationsverstärkers (24) angelegt wird.

6. Schaltungsanordnung nach Anspruch 5, dadurch gekennzeichnet, daß als Schwellenglied dem nichtinvertierenden Eingang des Differenzverstärkers (24) eine Diode
(D) vorgeschaltet ist.

7. Schaltungsanordnung nach einem der Ansprüche 3 bis 6,
dadurch gekennzeichnet, daß die Meßgröße über einen Vorverstärker (11, 22) an die Meßanordnung (16, 17, 24)
angelegt wird.

8. Schaltungsanordnung nach einem der Ansprüche 3 bis 7,
dadurch gekennzeichnet, daß der als Differenzverstärker
verwendete Operationsverstärker (24) im Schalterbetrieb
arbeitet und eine Mitkopplung aufweist mit einem veränderbaren ohmschen Widerstand (25) zur Veränderung der
Schalthysterese.

Fig. 1

Fig. 2

Fig. 3

Fig. 4

## EINSCHLÄGIGE DOKUMENTE

EP 83104385.6

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | CH - A5 - 624 799 (LICENTIA) <br> * Zusammenfassung; Fig. 1,2 * <br> ---- | 1,3,7 | H 02 H 3/44 <br> H 02 H 5/04 <br> G 01 R 19/12 |

**RECHERCHIERTE SACHGEBIETE (Int. Cl. ³)**

G 01 R 19/00
G 01 R 29/00
H 02 H 3/00
H 02 H 5/00
G 01 D 1/00

Der vorliegende Recherchenbericht wurde für alle Patentansprüche erstellt.

| Recherchenort | Abschlußdatum der Recherche | Prüfer |
|---|---|---|
| WIEN | 19-08-1983 | KUNZE |